# EUROPÄISCHE PATENTSCHRIFT

(11) **EP 1 523 755 B1**
(45) Veröffentlichungstag und Bekanntmachung des Hinweises auf die Patenterteilung: **14.06.2006**
(21) Anmeldenummer: 03765091.8
(22) Anmeldetag: 22.07.2003
(51) Int. Cl.: H01J 37/32

(54) **PLASMAREAKTOR ZUR DURCHFÜHRUNG VON GASREAKTIONEN UND VERFAHREN ZUR PLASMAGESTÜTZTEN UMSETZUNG VON GASEN**
PLASMA REACTOR FOR CARRYING OUT GAS REACTIONS AND METHOD FOR THE PLASMA-SUPPORTED REACTION OF GASES
REACTEUR A PLASMA DESTINE A LA MISE EN OEUVRE DE REACTIONS GAZEUSES ET PROCEDE DE TRANSFORMATION DE GAZ ASSISTEE PAR PLASMA

(30) Priorität: 23.07.2002 DE 10233538
(43) Veröffentlichungstag der Anmeldung: 20.04.2005
(73) Patentinhaber: Iplas Gmbh, 53842 Troisdorf (DE)
(72) Erfinder: SPITZL, Ralf, 53842 Troisdorf (DE); BEHR, Arno, 44137 Dortmund (DE); WOLFF, Christian, 44147 Dortmund (DE); OBERREUTHER, Thorsten, 44225 Dortmund (DE)
(74) Vertreter: Flaccus, Rolf-Dieter
(86) Internationale Anmeldenummer: PCT/EP2003/007993
(87) Internationale Veröffentlichungsnummer: WO 2004/010454

(56) Entgegenhaltungen:
- EP-A- 0 768 702
- WO-A-98/19965
- US-B1- 6 357 386
- PATENT ABSTRACTS OF JAPAN Bd. 0122, Nr. 07 (E-621), 14. Juni 1988 (1988-06-14) & JP 63 004615 A (HITACHI TOKYO ELECTRON CO LTD; others: 01), 9. Januar 1988 (1988-01-09)

## Beschreibung

Die Erfindung betrifft eine Vorrichtung zur Durchführung von Gasreaktionen mit einem gasdurchströmten, insbesondere großvolumigen Plasmareaktor mit einer, insbesondere zylindrischen, Plasmakammer. Die Erfindung betrifft weiterhin ein Verfahren zur Durchführung von Gasreaktionen bei dem ein Strom von Gasen oder vergasbaren Stoffen durch ein insbesondere von Mikrowellen angeregtes Plasma durchgeleitet wird.

Eine Vorrichtung aus einem insbesondere zylindrischen Plasmareaktor, dem Mikrowellen über Koppelstellen zugeleitet werden, kann von Gasen durchströmt werden, wobei durch hohe Anregung der Gase durch das Plasma Gasreaktionen stattfinden können, insbesondere können Stoffsynthesen und Reaktionen der Gasreinigung durchgeführt werden.

Bekannte Vorrichtungen zur Erzeugung eines Mikrowellenplasmas bestehen aus einer Plasmakammer, einem Mikrowellen zuführenden Resonator mit Mikrowellenerzeuger zur Bildung des Plasmas und Koppelstellen, z. B. regelmäßig angeordneten Schlitzen, Antennen o. dgl. in der Metallwand zwischen Resonator und Plasmakammer zur Einkopplung der Mikrowelle in die Plasmakammer.

Bekannte Plasmareaktoren zur Durchführung von Gasreaktionen nutzen thermische Plasmajets welche hohe Leistungen von mehreren 10kW benötigen und die Prozessgase auf mehrere 1000 oder gar 10000 K erhitzen. Herbei erfolgt der Leistungseintrag auf kleinen Plasmavolumen von einigen cm³ mit Leistungsdichten von einigen 1000-10000W/cm³.

Nach DE 19 600 223 umfaßt der Resonator als Ring von rechteckigem Querschnitt die Metallwand mit Koppelstellen der zylindrisch-rohrförmigen Plasmakammer.

Anordnungen nach z.B. DE19600223 erzeugen zwar Nichtgleichgewichts bzw. nichtthermische Plasmen in Plasmakammern mit einem Volumen von einigen 1000 cm³ und Leistungsdichten von einigen W/cm³ bei einer Mikrowellenanregungsfrequenz von 2,45GHz, erlauben aber nicht den Durchsatz großer Volumenströme und entsprechende Gasgeschwindigkeiten. Die Effizienz solcher nichtthermische Plasmen d.h. eingesetzte Leistung/Stoffumsatz ist deutlich besser, da nicht soviel Energie zum - in der Regel nutzlosen - Aufheizen des Neutralgases verschwendet wird.

Als Mikrowellenanregungsfrequenz sind insbesondere auch die kommerziell verwendeten 915 MHz bzw. 440 MHz mit entsprechend aufskalierten Plasmaquellen geeignet.

Bekannte und erfindungsgemäß benutzbare Resonatoren können auch eine zylindrische Wand der Plasmakammer mit Koppelstellen ganz oder als Segmente eines Mantels mit gleicher Längsachse umfassen oder innerhalb der zylindrischen Plasmakammer z. B. in deren Achse angeordnet sein. Durch die Geometrie des Resonators und der im wesentlichen rohrförmig-zylindrischen Plasmakammer sowie durch die regelmäßige Anordnung der Koppelstellen zwischen beiden entstehen im Inneren der Plasmakammer bestimmte Wellenbilder mit optimaler Wirksamkeit des Plasmas, d. h. sogenannte Moden. Der Mikrowellenerzeuger kann auch durch chemische, elektromagnetische bzw. Hochfrequenzanregung ergänzt oder ersetzt sein.

Gase in der Plasmakammer werden durch das Plasma angeregt, wobei u. a. Leuchterscheinungen entstehen. Nachteilig ist es bei den bekannten Reaktoren, dass ein Gasstrom schon bei geringer Strömungsgeschwindigkeit das Plasma stört, es aus der Kammer treibt und das Plasma abreißen läßt, welches damit erlöscht. Hohe Gasdurchsatzmengen und hohe Gasströmungsgeschwindigkeiten können mit den bekannten Reaktoren nicht erreicht werden.

Bekannte Gasreaktionen und Gassynthesen können auch im Lichtbogen mit Entladungselektroden erfolgen, wobei die Temperaturen für viele Zwecke zu hoch sind, eine Behinderung des Gasstroms durch die Elektroden erfolgt und der hohe Energieverbrauch nachteilig ist.

Eine Vorrichtung gemäβ der Oberbegriff der Ansprüche 1 and 8 ist aus WO 98/19965 bekannt.

Aufgabe der Erfindung ist es ein gut verteiltes, stabiles und insbesondere nichtthermisches Plasma und somit eine optimale Aktivierung des Gases, insbesondere bei hohe Durchsätzen zu erhalten, insbesondere solche mit Mikrowellen angeregte, d.h. elektrodenlose großvolumige Plasmaquellen für hohe Gasgeschwindigkeiten von einigen m/s bis einige 10 m/s nutzbar zu machen und einen stabilen Langzeitbetrieb insbesondere bei Drücken von einigen 100mbar bis einige10 bar zu gewährleisten.

Zur Lösung dieser Aufgabe wird ein gasdurchströmter Plasmareaktor für Gasreaktionen mit strömungsformenden Elementen zur Führung des Gasstroms gemäß Anspruch 1, sowie ein Verfahren zur Durchführung von Gasreaktionen mit hohen Volumenströmen mit dieser Vorrichtung vorgeschlagengemäß Anspruch 8.

Als Reaktionsgase kommen insbesondere schwer aktivierbare und damit wenig reaktive Gase z.B. Kohlendioxid, Wasser und auch Stickstoff, Methan und Erdgas in Frage.

Gemäß der Erfindung ist es in der Vorrichtung vorgesehen mittels der strömungsformenden Elemente die Ausbildung wenigstens einer strömungsberuhigten, insbesondere zentralen Zone im Gasstrom zu erzeugen. Innerhalb einer solchen beruhigten Zone kann das Plasma besonders stabil erzeugt werden.

Das Plasma bleibt auch bei hohen gesamten Gasströmungsgeschwindigkeiten stabil, da im stromungsberuhigten Bereich die Geschwindigkeit der Gasströmung herabgesetzt wird, so dass ein Abreissen des Plasmas selbst bei hohen Gasdurchsätzen verhindert wird.

Mittels der gasströmungsformenden Elemente wird insbesondere erreicht, dass es 1.) nur zu einem schwachen Plasma - Reaktorwand (Rezipient, der z.B. aus einem Quarzglas- oder Keramik Rohr ausgeführt ist) Kontakt kommt und zum anderen 2.) ein stömungsberuhigter Bereich (in der Regel im Zentrum der Plasmaquelle bzw. des Rezipienten) erzeugt wird.

Punkt 1.) führt zu einer hohen Standzeit der erfindungsgemäßen Vorrichtung aufgrund der geringen thermischen Belastung des Rezipienten und Punkt 2.) zu einem stabilen Leistungseintrag in das Plasma.

Die Erfindung betrifft großvolumige Plasmaquellen, d.h. Plasmaquellen bei denen das Plasmakammervolumen größer ist als das Volumen eines Lamdastückes (eine Wellenlänge) des zuführenden Mikrowellenleiters (i.d.Regel Hohlleiters) bzw./oder Plasmaquellen, deren Länge (in Strömungsrichtung) größer/gleich einer Wellenlänge sind.

Zu dem Plasmakammervolumen wird nicht der Remote-Bereich der Plasmaquelle gezählt, in dem das Plasma durch die Gasströmung ausgetrieben wird, sondern nur der Bereich, in welchem dem Plasma noch Mikrowellenleistung zugeführt wird.

Die Erfindung betrifft insbesondere nicht die bekannten Plasmajet / Plasmastrahlquellen, die kleine Plasmavolumen aufweisen. Ebenso betrifft die Erfindung nicht die bekannten Niederdruckplasmaquellen.

Die Vorrichtung weist erfindungsgemäß eine bevorzugt zylindrisch-rohrförmige gasdurchströmte Plasmakammer als Plasmareaktor mit Koppelstellen zur Zuführung der Mikrowellenleistung ggf. über einen Mikrowellen zuführenden Resonator sowie strömungsformende Elemente für den Gasstrom auf. Der zuführende Resonator kann z.B. als Hohlleiterring oder Koaxiatresonator als Mantel oder Teilmantel die Plasmakammer ganz oder zumindest teilweise umfassen, wobei die Plasmakammer selbst als Resonator Moden ausbilden kann.

Hierbei kann es vorgesehen sein, das Plasma gepulst zu betreiben, z.B. mit Pulsfrequenzen von 1 Hz bis 50 kHz. Das Pulsen kann erzeugt werden durch gepulste Ansteuerung des Mikrowellenerzeugers oder gepulste Einkopplung in den Plasmareaktor, insbesondere den Resonator. Hierdurch kann die Stoffumsetzung verbessert und der Energieeintrag vergrößert werden.

Die Erzeugung eines Plasmas über Mikrowellen hat den Vorteil, ein nichtthermisches Plasma erzeugen zu können, d.h. es handelt sich um ein Plasma, welches einen hohen Energieanteil hinsichtlich der Elektronenanregung aufweist, jedoch geringe thermische Aufheizung zeigt. Dies hat eine höhere Energieeffizienz im Vergleich zu anderen Plasmaerzeugungen, z.B. durch Lichtbogen zur Folge. Die benötigte Energie liegt etwa einen Faktor 10 bis 100 niedriger als bei der Erzeugung thermischer Plasmen.

An den Stirnflächen des Plasmareaktors können Anschlüsse zur Gaszufuhr und auf der Gegenseite Anschlüsse zum Gasaustritt vorgesehen sein, wobei die strömungsformenden Elemente bzw. Vorrichtungen die Gase verteilen und insbesondere einen rotierenden Gasstrom bewirken, in dessen zentralem Inneren die Rotationsgeschwindigkeit am geringsten ist, so dass sich im Rotationszentrum die strömungsberuhigte Zone ausbildet.

Eine Ausführung der Erfindung betrifft eine Anordnung, bei welchem der in die Plasmakammer zugeführte Gasstrom unmittelbar vor der Kammer mittels strömungsformender Elemente in Rotation versetzt wird.

Eine andere Ausführung sind strömungsförmende Elemente, die den Gastrom unmittelbar nach der Plasmakammer umlenken und dadurch eine Rotation des

Gasstroms in der Plasmaquelle bewirken.

Die bevorzugt zylindrisch geformte Plasmakammer und die Anordnung der Koppelstellen sowie insbesondere die Verteilung des Gasstroms mit wenigstens einer strömungsberuhigten Zone bewirken ein gut verteiltes und stabiles Plasma und somit eine optimale Aktivierung des Gases.

Das Verfahren hat den Vorteil, dass auch große Plasmen insbesondere bei der Mikrowellenfrequenz 2,45 GHz erzeugt werden können. So kann das Volumen der Plasmakammer bevorzugt im Bereich von 0,5 bis 5 Litern liegen. Es ergeben sich so Plasmaanregungszonen von ca. 1 bis 2 Litern Volumen, in denen bevorzugt eine Gasstromberuhigung erzeugt wird.

Eine bevorzugter Weise zur Achse das Reaktors symmetrische Anordnung der strömungsformenden Elemente kann ausgenutzt werden, um besonders effektiv eine Strömungsberuhigung zu erzeugen, insbesondere durch die genannte bevorzugte Rotation des Gasstroms. Die Verteilung und bevorzugte Rotation der Gase in der ganzen Plasmakammer des Reaktors und Reaktionsrohrs durch die strömungsformenden Elemente ermöglichen hohen Stoff- bzw. Gasdurchsatz und eine hohe Umsetzung der zur Reaktion zu bringenden Stoffe.

Die Zuführung der Mikrowellenleistung über die Koppelstellen erfolgt bevorzugt über zuführende Ring- oder Koaxialresonatoren, welche die Plasmakammer als Mantel bzw. Teilmantel umfassen können.

Als strömungsformende Elemente eignen sich u. a. Prallbleche, Düsen, Blenden, Gitter, Kegel, Prallkörper, Wirbelrohre, Zyklone,Turbinen oder Lochblenden, jeweils als Alternative oder auch in Kombination miteinander.

Bevorzugt ist es vorgesehen, dass die strömungsformenden Elemente einstellbar angeordnet sind, um so im Bedarfsfall den Gasstrom zu verstellen und beispielsweise den Gasstrom mehr oder weniger zu beruhigen.

Insbesondere einstellbare Ringblenden oder Ringdüsen in symmetrischer Anordnung zum zugeführten Gasstrom und der Achse und/oder tangential zuführende, ringförmig angeordnete Düsen ermöglichen die Rotation im Reaktor und Reaktionsrohr bzw. Nachreaktionsrohr. Solche strömungsformenden Elemente sind am Gaseintritt und am Gasaustritt des Reaktors und am Beginn des Reaktionsrohrs besonders wirksam.

Die strömungsformenden Elemente ermöglichen eine geordnete z. B. rotierende Gasführung und unerwartet hohe Gasgeschwindigkeit, d.h. hohe Durchsatzmengen, ohne daß das Plasma vollständig aus dem Reaktor getrieben wird, da die strömungsberuhigte Zone für ein stabiles Plasma Sorge trägt.

Die Anregung der Gase durch das Plasma kann im Reaktor erfolgen, während die weitere Reaktion der Gase erst im Reaktionsrohr erfolgt. Ein Teil des Gases oder eine von mehreren Reaktionskomponenten oder Inertgase können daher bevorzugt am Austritt des Reaktors dem Gasstrom zugeführt werden. Ebenso sind Hilfsstoffe am Gaseintritt oder im Reaktionsrohr zuführbar.

Die Vorrichtung mit den strömungsformenden Elementen macht es möglich, die Gase im Bereich des Atmosphärendrucks bei 0,1 bis 10 bar, besonders bei 0,3 bis 1,5 bar Druck zu handhaben. In z.B. 2,45 GHz-Reaktoren mit z.B. 100 mm Durchmesser werden Gasströme von 0,1 m³/h bis 300 m³/h, insbesondere von z.B. 10 bis 100 m³/h erreicht. Hierbei werden Gasgeschwindigkeiten von 1 bis 15 m/sec erreicht. Reaktoren bis 1000 mm Durchmesser ergeben wesentlich größere Durchsatzmengen von bis zu einigen 1000 m³/h.

Soweit ein Reaktionsrohr anschließt, hat dies bevorzugt die gleiche Achsrichtung, kann aber einen anderen Durchmesser haben.

Durch das Plasma werden die Gase so stark aktiviert, daß eine Kühlung der Gase von Vorteil oder notwendig sein kann. Dazu können Kühlelemente wie Kammern oder Kühlmäntel in der Wandung des Reaktionsrohrs und ggf. am Gaseintritt und Gasaustritt des Reaktors dienen.

Wirksame Kühlung kann inbesondere auch durch Gase als gekühlter Gasstrom oder als Zufuhr von kalten Gasen wie z.B. Argon oder bei Synthesen von Teilen der Reaktionspartner am Beginn oder in das Reaktionsrohr erfolgen. Durch gezielte Abkühlung ist eine selektive Produktbildung möglich. Kalte Gase werden bevorzugt mit Ringdüsen, Schlitzspalten oder tangential wirkenden Injektionsrohren zugeführt, wobei diese zugleich als strömungsformende Elemente wirken können. Durch diese Kühlelemente und die Zugabe von ggf. kalten Gasen sind für die jeweils durchgeführte Reaktion bzw. Umsetzung die Temperaturbereiche mit höchsten Umsatzgraden und Ausbeuten einstellbar. Bevorzugte Temperaturbereiche sind von 100 bis 1000 Grad Celsius. Es können Umsatzgrade von bis zu 100% und Ausbeuten im Bereich von 10% bis 100% erreicht.

Im Reaktor kann ein für die Mikrowellen durchlässiger Rezipient aus z.B. Quarzglas, Keramik o. dgl. parallel zur Zylinderwand angeordnet sein. Die Wand des Rezipienten kann sich in das Reaktionsrohr fortsetzen oder das Reaktionsrohr bilden.

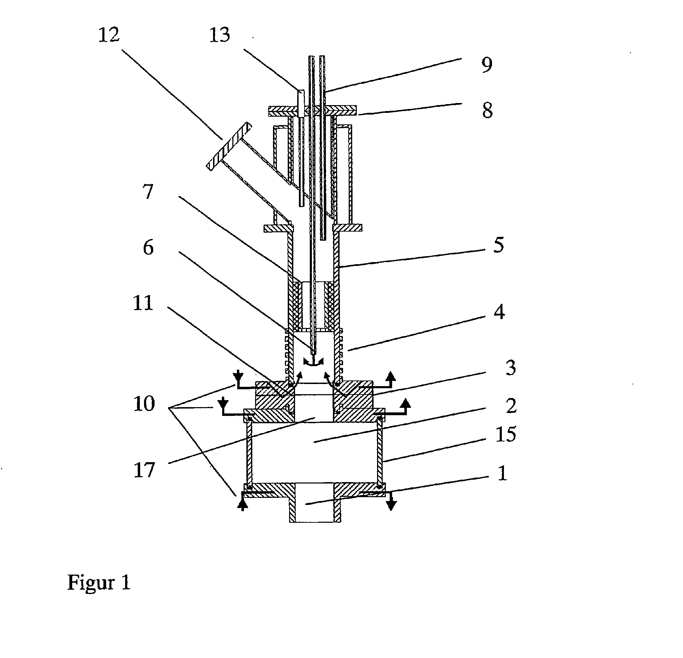

In das Reaktionsrohr können, besonders in Achsrichtung von hinten Messgeräte oder Rohre zur Probenentnahme und/oder eine verschiebbare Zufuhr weiterer Gase oder Kühlmittel hineinragen (siehe Fig.1). Im Reaktionsrohr können Katalysatoren aller Art zur Beschleunigung der jeweiligen Reaktionen eingesetzt werden, insbesondere auf Böden, bevorzugt in einem verschiebbaren Korb angeordnet sein oder als Granulate, Netze, o.ä.

Das Verfahren zur Durchführung von Gasreaktionen durch plasmagestützte Umsetzung kann insbesondere mit der beschriebenen Vorrichtung erfolgen. Die strömungsformenden Elemente bewirken eine Verteilung des Gases, die zu einer Beruhigung im Gasstrom führt, wobei besonders in der strömungsberuhigten Zones des Gasstromes das Plasma stabil brennen kann. Insbesondere ist eine Rotation des Gasstroms bevorzugt, wodurch die Strömungsgeschwindigkeit und die Durchsatzmenge sowie die Vollständigkeit der Umsetzung ganz wesentlich gesteigert werden kann. Durch Kühlung der Vorrichtung und durch die Zufuhr gekühlter Ausgangsstoffe, kalter Gase oder Hilfsstoffe steigt die Durchsatzmenge und in Abhängigkeit von der durchgeführten Reaktion der Umsatzgrad.

Im Plasmareaktor erfolgt die Aktivierung bzw. Anregung der Reaktionskomponenten. Eine Aktivierung der oberhalb der Plasmaquelle zugeführten Gase erfolgt im Eintritt in das Reaktionsrohr, soweit dorthin das Plasma mit dem Gasstrom ausgetragen wird, was immer dann möglich ist, wenn im Reaktor das Plasma stabil aufrecht erhalten bleibt. Die eigentliche Umsetzung erfolgt überwiegend im Reaktionsrohr.

Häufig ist es zweckmäßig, durch den Plasmareaktor nur einen Teil der Gase, oder nur eine von mehreren Reaktionskomponenten zu leiten und weitere Komponenten, Hilfsgase oder sogar flüssige Stoffe wie z.B. Wasser am Beginn des Reaktionsrohres einzuleiten. Besonders durch Zufuhr kalter Gase aller Art erst im Reaktionsrohr sowie durch Kühlung des Reaktionsrohrs wird die Temperatur der Reaktion gesteuert, die durchgesetzte Menge und der Umsatzgrad gesteigert.

Katalysatoren mit Eignung für die jeweils durchgeführte Reaktion können in bekannter Art und Form z.B. auf Trägern aufgebracht, im Reaktionsrohr auf Böden angeordnet oder vorteilhaft in einem verschiebbaren Katalysatorkorb benutzt werden. Empfindliche Katalysatoren können im hinteren Teil des Reaktionsrohrs z.B. direkt von kalten Gasen oder Hilfsgasen angeströmt werden. Fein verteilte Stäube, folglich auch fein verteilte Katalysatoren, Suspensionen oder katalytisch wirkende Gase können direkt durch den Plasmareaktor geführt werden.

Der Druck kann mit stationären oder gepulsten Plasmen in der Vorrichtung bei z.B. 0,1 bis10 bar besonders im Bereich des Normaldrucks liegen. Gasgeschwindigkeiten von z. B. 0,1 bis 10 m/s bei z.B. 100 mm Rohrdurchmesser, d. h. bei sehr geringem Durchmesser und kleiner Apparatur, sind möglich. Gasvolumenströme von 1 bis 300 m³/h werden erreicht. Bei Rohrdurchmessern von 300 bis 1000 mm sind entsprechend hohe Durchsatzmengen von 100 bis einigen 1000 m³ möglich.

Die Temperaturen der jeweiligen Gasreaktionen liegen durch die starke Plasmaanregung niedriger als bei entsprechenden Reaktionen bei Durchführung z.B. im Lichtbogen bzw. durch thermische Anregung. Es werden daher vorliegend insbesondere sogenannte nichtthermische Plasmen in einem Temperaturbereich von bevorzugt 200 bis 2000 Grad Celsius erzeugt. Das Material der Vorrichtung, u.a. Edelstahl oder Quarzglas, wird daher wenig belastet, erleidet keine Materialschäden oder Korrosion und hat eine lange Lebensdauer. Auch die Katalysatoren haben lange Standzeiten.

Die Reinigung von Abgasen bzw. Restgasen z.B. industrieller Prozesse und auch Stoffsynthesen sind aus Gasen oder vergasbaren Flüssigkeiten in der Gasphase durchführbar, insbesondere aus schwer aktivierbaren Gasen wie CO₂, N₂, SF₆, CF₄, C2F₆ oder H₂O. Gas- oder dampfförmige Schadstoffe können mittels eines geeigneten Reduktions oder Oxidationsmittels in einem Abgasstrom vernichtet werden.

Häufig können hohe Ausbeuten und Umsatzgrade von bis zu 100% erreicht werden.

Zur Produktion von Synthesegas können Wasserdampf und Kohlenwasserstoffe zum Einsatz kommen. Ebenso kann die Produktion von Synthesegas aus flüssigen oder gasförmigen Kohlenwasserstoffen und Kohlendioxid bei Neutralgastemperaturen unter 1000°C mit und ohne Einsatz von Katalysatoren erfolgen.

Zur Herstellung von Wasserstoff kann z.B. Erdgas mittels Argon- oder Wasserstoffplasmen umgesetzt werden.

Beispiele für Stoffsynthesen aus Gasen sind die Herstellung von Ammoniak aus Stickstoff und Wasserstoff im mol-Verhältnis 1:3 sowie Pyrolysereaktionen, z. B. die Zersetzung von Methan oder anderen Kohlenwasserstoffen zu Wasserstoff und feinteiligem, hochaktiven Ruß, der zahlreiche Verwendungen u. a. als Toner für Kopiergeräte hat. Eine wichtige Reaktion ist die Herstellung von Synthesegas, d.h. von CO und H₂ aus Methan oder niederen Kohlenwasserstoffen. Dabei sind Abweichungen von 20% von den theoretischen mol-Mengen möglich. Die Umsetzung von trockenem Wasserdampf mit Methan verläuft im mol-Verhältnis 1:1 und liefert theoretisch 3 mol H₂ je mol CO und wird daher überwiegend zur Herstellung von Wasserstoff genutzt. Die Umsetzung von CO₂ mit Kohlenwasserstoffen, berechnet als Methan, liefert gleiche mol-Mengen CO und H₂ und dient zur Herstellung nachfolgender Produkte aus Synthesegas. Ein Überschuß von Methan bzw. die Zufügung oder Rückführung von Wasserstoff vermindert Nebenreaktionen und lässt Umsätze bis sogar 98% bei sehr hoher Selektivität erreichen. Wasserstoff oder zurückgeführtes Synthesegas kann z.B. über die Ringdüse 11 nach Fig. 1 zugegeben werden.

Der Einsatz von Katalysatoren ist im Reaktionsrohr möglich. Dies gilt insbesondere für heterogene Katalysatoren auf geeigneten Trägern, wie z.B. Aluminiumoxid oder Siliziumcarbid. Als Katalysatoren sind zudem auch beschichtete Monolithen sowie Zeolithe mit und ohne Dotierung geeignet.

Als aktive Komponenten des Katalysators kommen z.B. sämtliche metallischen Oxide z.B. Eisen,- Kupfer-, Zink- oder Nickeloxid sowie gemischte Oxide mehrerer Metalle in Frage. Neben den Oxiden sind auch Reinmetalle verwendbar. Dies sind z.B. Palladium, Platin, Rhodium sowie Kupfer, Eisen, Kobalt, Titan, Nickel sowie Zink.

Die Katalysatoreinbringung im Reaktionsrohr erfolgt dabei vorzugsweise auf verschiebbaren Böden.

Hochwertige langkettige und/oder aromatische Kohlenwassertstoffe können durch den Einsatz gasförmiger Olefine durch Zuführung mit und ohne Reaktion mit Kohlendioxid mit und ohne Katalysatoren entstehen.

Mögliche Reaktionen mit Katalysatoren sind die Bildung längerkettiger Kohlenwasserstoffe mit und ohne Sauerstoffeinbau ähnlich der Fischer-Tropsch-Synthese, aromatische Moleküle, die Ammoniaksynthese sowie die Ausbeutesteigerung nebst Rußvermeidung bei der Synthesegasproduktion. Das Verfahren eignet sich somit zur Produktion von Ammoniak oder Hydrazin aus Gemischen von Wasserstoff und Stickstoff mit und ohne Einsatz von Katalysatoren.

Die Abgasreinigung bewirkt die vollständige Oxidation vielfältiger Abgase von unerwünschten, schädlichen oder giftigen Bestandteilen wie Kohlenmonoxid, Dioxin, Furanen, FCKW, FKW, CKW und weiteren Kohlenstoffverbindungen. Die Vorrichtung erlaubt durch die Gaszuleitungen die Zufuhr von z.B. Luft oder Sauerstoff bzw. von reduzierenden Gasen wie Ammoniak, Wasserstoff bzw. deren Mischungen mit einem Abgas. Durch Wahl geeigneter Temperaturen, durch Wahl geeigneter Zusatzstoffe sowie wirksamer Katalysatoren können somit auch schwer bzw. häufig unvollständig umsetzbare Abgase gereinigt werden.

Beispiele für umsetzbare Abgase sind Reste aus der Gewinnung und Verarbeitung von Erdöl und Erdgas, aus chemischen Umsetzungen, soweit Reste der Ausgangsstoffe bzw. Produkte eine Wiedergewinnung nicht lohnen bzw. eine Reinigung durch Oxidation bzw. Reduktion ohne weitere Umsetzung vor Abführung nach Außen erforderlich ist.

In der Zeichnung der Figuren 1 bis 4 ist im Schnitt die erfindungsgemäße Vorrichtung zur Durchführung von Gasreaktionen durch Plasmabehandlung dargestellt. In der Zeichnung sind zum Teil der bekannte zuführende Resonator sowie die Koppelelemente in der Wand des Plasmareaktors fortgelassen.

Fig. 1 zeigt diese Vorrichtung, worin von unten durch die Stirnfläche der Plasmakammer mittels des als strömungsformendes Element ausgebildeten Gaseintritts 1 ein z.B. rotierender Gasstrom der Ausgangsstoffe eingeführt, im Plasmareaktor bzw. in der Plasmakammer 2 verteilt und durch das Reaktionsrohr 5 mit gleicher Achse wie der Reaktor weitergeführt, zur vollständigen Reaktion gebracht und schließlich am Gasaustritt 12 abgeführt wird.

Ringförmig ausgebildete Kühlkammern 10 und gekühlte Ringe 3 sind am Gaseintritt in den Reaktor und am Gasauslass aus dem Reaktor bzw. Eintritt in das Reaktionsrohr angeordnet. Zuleitungen für weitere Gase bzw. Hilfsstoffe sind als ringförmige Düsen 11 am Auslass des Reaktors und als verschiebbares achsiales Rohr 6 mit Gaseinführung entgegen dem Gasstrom angeordnet. Durch den Kühlkopf 8 ist ein Meßgerät 13 und eine verschiebbare Probenentnahme 9 geführt.

Soweit das Reaktionsrohr 5 aus Glas, Quarz o. dgl. besteht, kann es durch ein Schutzrohr 4 aus Metall umfaßt werden. Der verschiebbar angeordnete Katalysatorkorb 7 enthält einen gekörnten oder auf einen Träger aufgebrachten Katalysator, welcher die jeweils durchgeführte Gasreaktion beschleunigt.

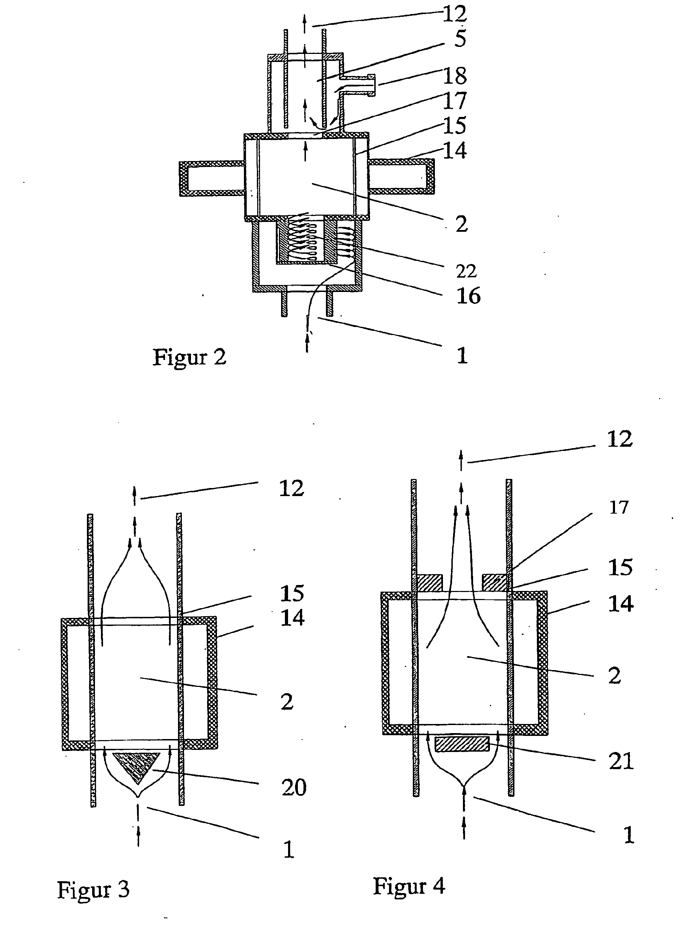

Fig. 2 zeigt im Schnitt eine Vorrichtung zur Gasbehandlung mit Plasmakammer 2, den Plasma zuführenden ringförmigen Plasmaresonator 14 und den Rezipient 15 aus Quarz. Die vom Gaseintritt 1 kommenden Gase werden von dem strömungsformenden Element 16 in Art einer Wirbelkammer durch in Reihen angeordnete Bohrungen 22 tangential zur Achse in durch Pfeile angedeuteter Rotation mit hoher Geschwindigkeit durch die Plasmakammer 2 zur Lochblende 17 in das Reaktionsrohr 5 zur Nachreaktion geführt. Durch den Rohrstutzen 18 wird weiteres Gas oder eine Reaktionskomponente in einen das Reaktionsrohr 5 umfassenden Mantelraum und durch den Ringspalt 19 in das Reaktionsrohr 5 in Richtung des Gasaustritts 12 geführt.

Fig. 3 zeigt im Schnitt eine Vorrichtung zur Plasmabehandlung mit schematisch angedeuteter Plasmakammer 2 und als Reaktionsrohr weiterführenden Rezipienten 15 aus Quarzglas. Als strömungsformendes Element im Gaseintritt 1 verteilt Kegel 20 den durch Pfeile angedeudeten Gasstrom und führt durch die Plasmakammer zum nicht gezeigten Gasaustritt. Hinter dem Kegel ergibt sich ein zentraler strömungsberuhigter Bereich

Fig. 4 zeigt im Schnitt eine Vorrichtung wie Fig. 3 mit einem verschiebbaren Ringspalt 21 am Gaseintritt 1 und eine zum Reaktionsrohr führende Lochblende 17. Das Reaktionsrohr und die Plasmakammer besitzen eine durchgehende Wandung 15. Suspensionen und Feinteilige Granulate können mit den Gasen durch den Plasmareaktor 2 und das Reaktionsrohr geführt und am Austritt abgeschieden werden.

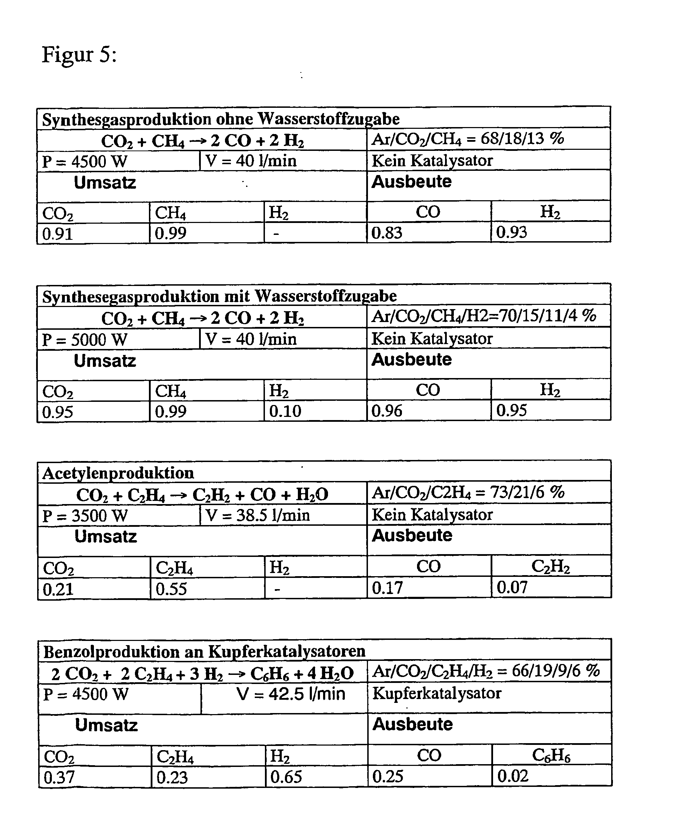

Fig. 5 zeigt Beispiele möglicher Reaktionen.

## Patentansprüche

1. Vorrichtung zur Durchführung von Gasreaktionen umfassend einen gasdurchströmten Plasmareaktor mit einer insbesondere zylindrischen Plasmakammer, wobei strömungsformende Elemente für die Gase vor und/oder in und/oder nach dem Plasmareaktor angeordnet sind, um einen Gasstrom in der Plasmakammer derart zu formen, dass sich wenigstens eine strömungsberuhigte, insbesondere zentrale, Zone im Gasstrom ausbildet, **dadurch gekennzeichnet, daß** die strömungsformenden Elemente einstellbar angeordnet sind

2. Vorrichtung nach Anspruch 1, **dadurch gekennzeichnet, daß** die im Gasstrom angeordneten sirömungsformenden Elemente als Kegel (20), Tropfen, Ringspalte (21), Blenden, Gitter, Prallkörper, Wirbelrohre (16), Zyklone oder Turbinen ausgebildet sind.

3. Vorrichtung nach einem der vorangehenden Ansprüche, **dadurch gekennzeichnet, daß** ein Reaktionsrohr axial hinter dem Reaktor angeordnet ist.

4. Vorrichtung nach einem der vorangehenden Ansprüche, **dadurch gekennzeichnet, daß** Kühlkammern am Eingang und/oder Ausgang des Reaktors und/oder in und/oder an der Wand des Reaktionsrohrs angeordnet sind.

5. Vorrichtung nach einem der vorangehenden Ansprüche, **dadurch gekennzeichnet, daß** Einleitungselemente, insbesondere Düsen, Spalte oder Rohre, zur Einleitung von Kühlmedien, insbesonderem kalter Gase, flüssige Stoffe oder Teilen der Ausgangsstoffe vorgesehen sind.

6. Vorrichtung nach Anspruch 5, **dadurch gekennzeichnet, dass** die Einleitungselemente strömungsförmende Elemente bilden.

7. Vorrichtung nach einem der vorherigen Ansprüche, **dadurch gekennzeichnet, daß** im Reaktionsrohr Katalysatoren insbesondere verschiebbar angeordnet sind, insbesondere heterogene Katalysatoren auf Böden, in einem Korb oder als Monolith.

8. Verfahren zur Durchführung von Gasreaktionen unter Durchleitung eines Stroms von Gasen oder vergasbaren Stoffen durch ein von Mikrowellen angeregtes insbesondere Nichtgleichgewichts-Plasma in einer Plasmakammer eines Plasmareaktors zur Umsetzung der Bestandteile, insbesondere in einer Vorrichtung nach einem der vorherigen Ansprüche **dadurch gekennzeichnet, dass** mittels einstellbarer strömunsgformender Elemente wenigstens eine strömungsberuhigte Zone im Gasstrom ausgebildet wird zur Erzeugung eines stabilen Plasmas innerhalb einer solchen Zone.

9. Verfahren nach Anspruch 8, **dadurch gekennzeichnet, daß** durch die strömungsformenden Elemente eine Rotation des Gasstromes erreicht wird.

10. Verfahren nach einem der vorherigen Ansprüche, **dadurch gekennzeichnet, daß** Wärme mittels eines im Reaktionsrohr integrierten Wärmetauschers rückgewonnen wird, insbesondere unter Verwendung einer schwarzen Austauschfläche zur Nutzung der Strahlungsenergie.

11. Verfahren nach einem der vorherigen Ansprüche, **dadurch gekennzeichnet, daß** Gase oder Aerosole, insbesondere Wasserstoff zur Temperatursteuerung eingedüst wird, insbesondere in der Reaktions- bzw. Rekombinationszone und insbesondere zur effizienteren Aktivierung hinter dem Plasma mittels der Zuführungen (3).

12. Verfahren nach einem der vorherigen Ansprüche, **dadurch gekennzeichnet, daß** das Plasma gepulst betrieben wird, insbesondere durch gepulste Ansteuerung des Mikrowellenerzeugers und/oder gepulste Einkopplung der Mikrowellen in den Resonator, insbesondere bei Puls-Frequenzen von 1 Hz bis 50 kHz.

## Claims

1. Device for carrying out gas reactions, comprising a plasma reactor with a through-flow of gases which has a plasma chamber, particularly a cylindrical plasma chamber, wherein flow-forming elements for forming the flow of gases are arranged before and/or in and/or after the plasma reactor in order to form a gas stream within the plasma chamber such that at least one, particularly central, zone in the gas flow is formed which is flow-reduced, **characterized in that** said flow-forming elements are arranged so as to be adjustable.

2. Device according to claim 1, **characterized in that** the flow-forming elements arranged in the gas stream are configured as cones (20), drops, annular gap (21), diaphragms, grids, baffle bodies, vortex tubes (16), cyclones or turbines.

3. Device according to any one of the preceding claims, **characterized in that** a reaction tube is arranged axially after the reactor.

4. Device according to any one of the preceding claims, **characterized in that** cooling chambers are arranged at the inlet and/or outlet of the reactor and/or in and/or on the wall of the reaction tube.

5. Device according to any one of the preceding claims, **characterized in that** feed elements, particularly nozzles, slots or tubes, are provided for introduction of cooling medium, particularly cold gases, liquid substances or part of the starting materials.

6. Device according to claim 5, **characterized in that** the feed elements form flow-forming elements.

7. Device according to any one of the preceding claims, **characterized in that** catalysts are arranged in the reaction tube, in particular so as to be displaceable, said catalysts in particular being heterogeneous catalysts on bottoms, in a basket, or as a monolith.

8. Method for carrying out gas reactions by passing a stream of gas or of gasifiable substances through a microwave-excited plasma in a plasma chamber of a plasma reactor, particularly a non-equilibrium plasma, in order to convert the components, particularly in a device according to any one of the preceding claims, **characterized in that** by means of adjustable flow-forming elements at least one flow-reduced zone is formed in the gas stream in order to produce a stable plasma within such a zone.

9. Process according to claim 8, **characterized in that** by means of the flow-forming elements a rotation of the gas stream is achieved.

10. Process according to any one of the preceding claims, **characterized in that** heat is recovered by means of a heat exchanger integrated in the reaction tube, in particular by using a black exchange surface for exploitation of the radiation energy.

11. Process according to any one of the preceding claims, **characterized in that** gases or aerosols, particularly hydrogen, are introduced via nozzles in order to control the temperature, in particular in the reaction or recombination zone, and in particular in order to achieve a more efficient activation after the plasma by means of the feeds (3).

12. Process according to any one of the preceding claims, **characterized in that** the plasma is pulse-operated, particularly by pulsed control of the microwave generator and/or pulsed coupling of the microwaves into the resonator, particularly at pulse frequencies from 1 Hz to 50 kHz.

## Revendications

1. Dispositif pour réaliser des réactions gazeuses, comprenant un réacteur à plasma traversé par des gaz avec une chambre à plasma en particulier cylindrique, où sont disposés des éléments formant écoulement pour les gaz avant et/ou dans et/ou après le réacteur à plasma, pour former un courant gazeux dans la chambre à plasma de manière qu'il se forme dans le courant gazeux au moins une zone à écoulement calme, en particulier centrale, **caractérisé en ce que** les éléments formant écoulement sont disposés de manière orientable.

2. Dispositif selon la revendication 1, **caractérisé en ce que** les éléments formant écoulement disposés dans le courant gazeux sont en forme de cône (20), de goutte, de fentes annulaire (21), de diaphragme, de grille, de chicanes, de tube à tourbillon (16), de cyclones ou de turbines.

3. Dispositif selon l'une des revendications précédentes, **caractérisé en ce qu'**un tube à réaction est disposé de façon axiale derrière le réacteur.

4. Dispositif selon l'une des revendications précédentes, **caractérisé en ce que** des chambres réfrigérantes sont disposées à l'entrée et/ou à la sortie du réacteur et/ou dans et/ou sur la paroi du tube à réaction.

5. Dispositif selon l'une des revendications précédentes, **caractérisé en ce que** sont prévus des éléments d'introduction, en particulier des buses, des fentes ou des tubes, pour introduire des milieux réfrigérants, en particulier des gaz froids, des matières liquides ou des parties des produits de départ.

6. Dispositif selon la revendication 5, **caractérisé en ce que** les éléments d'introduction forment des éléments formant écoulement.

7. Dispositif selon l'une des revendications précédentes, **caractérisé en ce que** des catalyseurs sont disposés en particulier de manière déplaçable dans le tube à réaction, en particulier des catalyseurs hétérogènes sur des étages, dans une cage ou sous forme de monolithe.

8. Dispositif pour réaliser des réactions gazeuses en faisant passer un courant de gaz ou de matières gazéifiables à travers un plasma excité par des micro-ondes, en particulier un plasma qui n'est pas à l'équilibre, dans une chambre à plasma d'un réacteur à plasma en vue de la réaction des constituants, en particulier dans un dispositif selon l'une des revendications précédentes, **caractérisé en ce qu'**au moyen d'éléments formant écoulement réglables, on forme au moins une zone d'écoulement calme dans le courant gazeux pour la production d'un plasma stable à l'intérieur d'une telle zone.

9. Procédé selon la revendication 8, **caractérisé en ce qu'**on obtient une rotation du courant gazeux grâce aux éléments formant écoulement.

10. Procédé selon l'une des revendications précédentes, **caractérisé en ce qu'**on récupère de la chaleur au moyen d'un échangeur de chaleur intégré dans le tube à réaction, en particulier en faisant appel à une surface d'échange noire pour utiliser l'énergie de rayonnement.

11. Procédé selon l'une des revendications précédentes, **caractérisé en ce qu'**on introduit par une buse des gaz ou des aérosols, en particulier de l'hydrogène pour le réglage de la température, en particulier dans la zone de réaction, respectivement de recombinaison, et en particulier en vue d'une activation efficace derrière le plasma au moyen des conduites (3).

12. Procédé selon l'une des revendications précédentes, **caractérisé en ce que** le plasma est opéré de manière pulsée, en particulier au moyen d'un réglage pulsé de l'appareil de production de micro-ondes et/ou par couplage pulsé des micro-ondes dans le résonateur, en particulier à des fréquences d'impulsions de 1 Hz à 50 kHz.
